# EUROPEAN PATENT SPECIFICATION

(11) **EP 2 207 749 B1**
(45) Date of publication and mention of the grant of the patent: **20.05.2015**
(21) Application number: 08838017.5
(22) Date of filing: 03.10.2008
(51) Int. Cl.: B81C 1/00

(54) **METHODS FOR MANUFACTURING A MICROSTRUCTURE**
VERFAHREN ZUR HERSTELLUNG EINER MIKROSTRUKTUR
PROCÉDÉS DE FABRICATION D'UNE MICROSTRUCTURE

(30) Priority: 09.10.2007 NL 1034489
(43) Date of publication of application: 21.07.2010
(73) Proprietor: Micronit Microfluidics B.V., 7521 PV Enschede (NL)
(72) Inventor: VAN'T OEVER, Ronny, NL-7415 CR Deventer (NL); BLOM, Marko, Theodoor, NL-7534 NK Enschede (NL); OONK, Johannes, NL-7545 KG Enschede (NL)
(74) Representative: Land, Addick Adrianus Gosling
(86) International application number: PCT/NL2008/000217
(87) International publication number: WO 2009/048321

(56) References cited:
- EP-A- 0 905 768
- WO-A-03/007026
- US-A- 4 911 783
- US-A- 4 957 592
- US-A1- 2003 027 425
- US-B1- 6 555 479

## Description

### Field of the invention

The invention relates to methods for manufacturing a microstructure, wherein use is made of powder blasting and/or etching and a mask layer. 'Microstructure' is defined within the scope of the invention as a 'structure characterized by its very small size, in particular within the range of 10⁻⁴ to 10⁻⁷ metre, i.e. the significant features in at least one direction cannot be fully discerned without the aid of an optical microscope', see also the notes under IPC class B81. In the context of the invention 'structure' is understood to mean a cavity, recess, reservoir, channel, tunnel, opening, passage and so forth, and all possible combinations thereof.

### Background of the invention

Microfluidics is concerned with microstructural devices and systems with fluidic functions. This may involve the manipulation of very small quantities of fluid, i.e. liquid or gas, in the order of microlitres, nanolitres or even picolitres. Important applications lie in the field of biotechnology, chemical analysis, medical testing, process monitoring and environmental measurements. A more or less complete miniature analysis system or synthesis system can herein be realized on a microchip, a so-called 'lab-on-a-chip' or, in specific applications, a so-called 'biochip'. The device or the system can comprise microfluidic components such as microchannels, microtunnels or microcapillaries, mixers, reservoirs, diffusion chambers, pumps, valves and so forth.

The microchip is usually built up of one or more layers of glass, silicon or a plastic such as a polymer. Glass in particular is very suitable for many applications because of a number of properties. Glass has been known for many centuries and there are many types and compositions readily available at low cost. In addition, glass is hydrophilic, chemically inert, stable, optically transparent, non-porous and suitable for prototyping; properties which are in many cases advantageous or required.

For the purpose of realizing cavities, recesses, reservoirs, channels, tunnels, openings, passages and so forth use can be made of mechanical abrasion such as sandblasting or powder blasting, particularly in the case of glass. Use can however also be made of etching, such as chemical and/or physical etching by means of a liquid (wet chemical etching) or a gas (dry etching, RIE, plasma etching), particularly in the case of silicon. It is noted here that the term 'etching' is generally used only for chemical and/or physical etching, although it is sometimes also understood to mean mechanical abrasion. In the context of the invention the terms 'powder blasting' and 'etching' will be used at all times, wherein powder blasting also includes sandblasting.

In powder blasting or etching of a desired microstructure use is usually made of a patterned mask layer. Two phenomena will occur here to greater or lesser extent which are usually deemed as being adverse: firstly mask erosion, and secondly 'blast lag' or 'etch lag'. Mask erosion occurs when the mask layer is eroded during the powder blasting or etching of the desired microstructure by the chemical and/or physical processes occurring therein. The mask material and the mask thickness are now chosen such that this erosion will be slight, at least so small that the mask layer will withstand the process sufficiently well. 'Blast lag' or 'etch lag' indicates that the blasting speed or etching speed, and thereby the blasting depth or the etching depth at a given point in time, depend on the form and dimensions of the opening in the mask layer. This dependence is in turn subject to the type of process and the process parameters. The smaller the dimensions of the opening, the smaller the blasting speed or the etching speed will generally be. 'Blast lag' and 'etch lag' are as a rule undesirable, although advantageous use can also be made thereof, see for instance US 2005/0148158 which describes how in a single process step a relatively shallow and narrow breaking groove is arranged simultaneously with relatively deep and wide fluidic structures by making clever use of 'blast lag'. US 2003/0027425 provides further examples of the manufacture by means of sandblasting of structures with differing depths making use of the phenomenon that the blasting speed, and thereby the blasting depth, depend on the size and the form of the relevant opening in a mask layer. WO 03/007026 provides similar examples, but then for isotropic etching.

WO 2007/000363 and US 2007/0065967 describe processes for forming a cavity by means of chemical etching using a mask layer in the form of a pattern of holes. US 2005/0113004 and US 6422920 provide examples of the use of powder blasting for the purpose of making recesses, passages, cavities or openings with a special form. GB 2375063 and GB 2375064 relate to powder blasting wherein use is made of multiple 'blast guns' and of particles having a range of sizes. Described herein is how different forms of cavity, channel and so on can also be realized in a single process step by making use of the phenomenon of 'blast lag' and by varying the angle of incidence of the particles, their size, the mask form, the number of 'guns' and so forth.

Use of the phenomenon of 'blast lag' is thus known for the purpose of obtaining a cavity, recess, reservoir, channel and so on of a desired specific form. The form and the dimensions of the mask layer, for instance a determined pattern of holes, must here be chosen correctly for the given process. The realizing of multiple types of cavity, recess, reservoir, channel and so on of mutually differing forms and dimensions in a single process step is also known. The number of possible forms and dimensions, and combinations thereof, does however remain limited because for a given process there is a determined fixed relation between on the one hand the blasting speed or etching speed, and thereby the blasting depth or the etching depth at a given point in time, and on the other the dimensions of the blasting opening or the etching opening in the mask layer.

US 4957592 describes a method for forming structures with differing depths in silicon by means of anisotropic etching, wherein use is made of a mask layer consisting of a non-erodable part (22) and an erodable part (18). At a given moment during the etching process the erodable part will have been worn away, after which the underlying silicon will also be etched. The design options are hereby increased, although the build-up of the non-homogeneous mask layer comprises multiple steps and is therefore relatively complex and expensive. US 5173442 describes the forming of structures of differing depths in a substrate by means of dry or wet etching, wherein use is made of a mask layer built up of multiple layers, for instance a hard lower layer (16) with a soft upper layer (18), or two stacked soft layers (30,34) with mutually differing patterns. Here also the design options are increased, although here too the build-up of the non-homogeneous mask layer comprises multiple steps and is therefore relatively complex and expensive.

There now exists a need for an improved method for manufacturing a microstructure wherein use is made of powder blasting and/or etching, which method comprises relatively few steps and provides more options relative to known methods and with which a wider variety of cavities, recesses, reservoirs, channels and so forth, and combinations thereof, can be realized, and in some cases preferably in a single process step. The object of the invention is to fulfil this need.

### Summary of the invention

The invention provides for this purpose methods for manufacturing a microstructure, wherein use is made of powder blasting and/or etching and a single mask layer with openings and structures of varying dimensions, characterized in that the mask layer at least at one given point in time has been wholly worn away within at least one region by mask erosion while the microstructure is not yet wholly realized. A 'single mask layer' is understood here and in the following to mean a layer which is arranged in a single process step and which is patterned in a single process step, with a substantially uniform thickness and substantially uniform properties. In particular the invention relates to a method for manufacturing a microstructure, wherein use is made of powder blasting or etching, comprising the step of providing a substrate having arranged thereon a single mask layer with a substantially uniform thickness with openings and structures of varying dimensions, further comprising at least one of the steps of:
powder blasting the mask layer and the substrate until at least one given point in time, wherein the blasting speed for smaller sized openings is lower than for larger openings due to blast lag, and wherein the mask layer has been wholly worn away within at least one region by mask erosion while the microstructure is not yet wholly realized; and
etching the mask layer and the substrate until at least one given point in time wherein the etching speed for smaller sized openings is lower than for larger openings due to etch lag, and wherein the mask layer has been wholly worn away within at least one region by mask erosion while the microstructure is not yet wholly realized.

Use can be made here of a combination of 'vertical' erosion, i.e. parallel to the thickness direction, and 'horizontal' erosion, i.e. perpendicularly of the thickness direction, of the mask layer. The horizontal mask erosion occurs at the edges of the mask structure. By selecting the size of the mask openings and the mask structures in a correct manner the mask layer in a region with smaller mask structures will hereby be fully worn away at a given point in time, while in another region with larger structures the mask layer still has sufficient thickness to serve as protection against the powder blasting or etching.

After the at least one given point in time the microstructure can be fully realized, wherein use can once again be made of powder blasting and/or etching. Preferably, the method further comprises the step of:
powder blasting the mask layer and the substrate after the at least one given point in time until the microstructure is fully realized.

Alternatively, the method further comprises the step of:
etching the mask layer and the microstructure after the at least one given point in time until the microstructure is fully realized. There can also be a plurality of regions with different sizes of mask structure, wherein the mask layer is worn away in each region at a determined point in time. All possible combinations of the use of powder blasting and/or etching for wearing away the mask layer in one or more regions and for realizing the whole microstructure fall within the scope of the invention.

Such methods provide more options relative to known methods because it is now also possible to vary the point or points in time at which the mask layer is worn away in a determined region or determined regions by mask erosion. This is possible by selecting a suitable combination of process, mask material, mask pattern and mask thickness. A method according to the invention has the advantage that for instance in a single process run, with a single lithographic step, a mask structure can be defined and a structure with components having different blast depth or etch depth can subsequently be realized, while normally necessary for this purpose are two or more separate process runs with separate lithographic steps, or a mask layer built up of multiple parts and/or multiple layers with different properties and/or patterns. It will be apparent that this will result in a great cost advantage. This will be further elucidated in the following description of exemplary embodiments of methods according to the invention.

### Brief description of the figures

The invention is elucidated hereinbelow on the basis of two exemplary embodiments of a method according to the invention. Herein:
- Figure 1 shows schematically process steps of a first exemplary embodiment of a method according to the invention; and
- Figure 2 shows schematically process steps of a second exemplary embodiment of a method according to the invention.

### Exemplary embodiments of methods according to the invention

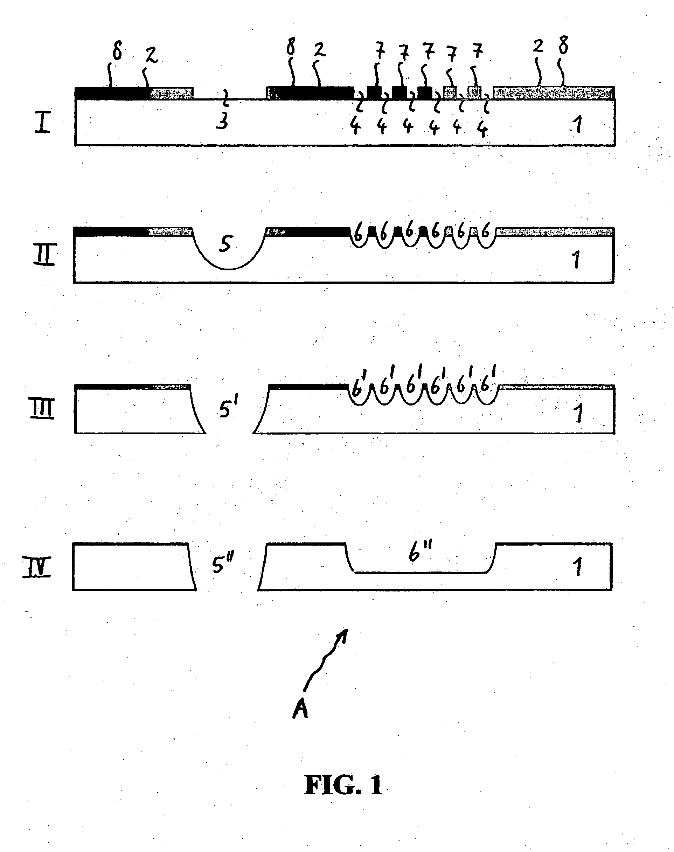

Figure 1 shows schematically a process (I-IV) for manufacturing a microstructure (A). Use is made (I) of a substrate (1) having arranged thereon a mask layer (2) comprising a larger opening (3), a plurality of smaller openings (4), a first region with larger mask structures (8) and a second region with smaller mask structures (7). A start is made with powder blasting, wherein 'blast lag' ensures that the blasting speed for the smaller openings (4) is lower than for the larger opening (3). After a period of time (II) a larger and deeper cavity (5) will be created in addition to a plurality of smaller and shallower cavities (6). The process and the pattern (3,4,7,8) of mask layer (2) are chosen such that, at a given point in time (III), a passage (5') is then created while the mask layer in the second region is then almost wholly worn away by a combination of vertical and horizontal mask erosion, but in the first region the thickness of the mask layer is still sufficient to protect the underlying material. After the given point in time (III) powder blasting is continued, wherein the mask layer in the second region is wholly worn away and the desired microstructure (A) is finally created. In a single process step and with a single mask layer (2) a microstructure (A) can thus be manufactured comprising a passage (5") and a recess (6") of a determined desired depth. The part of the mask layer in the second region almost wholly worn away following step II-III can optionally also be removed by means of an etchant, after which the powder blasting is resumed in order to arrive at the desired structure (A). Etching could also have been used in the final step (III-IV). It is also possible to envisage such a microstructure (A) according to the invention being manufactured by using a suitable etching process during the first steps (I-II, II-III) and subsequently continuing with etching (III-IV) or, conversely, then switching to powder blasting (III).

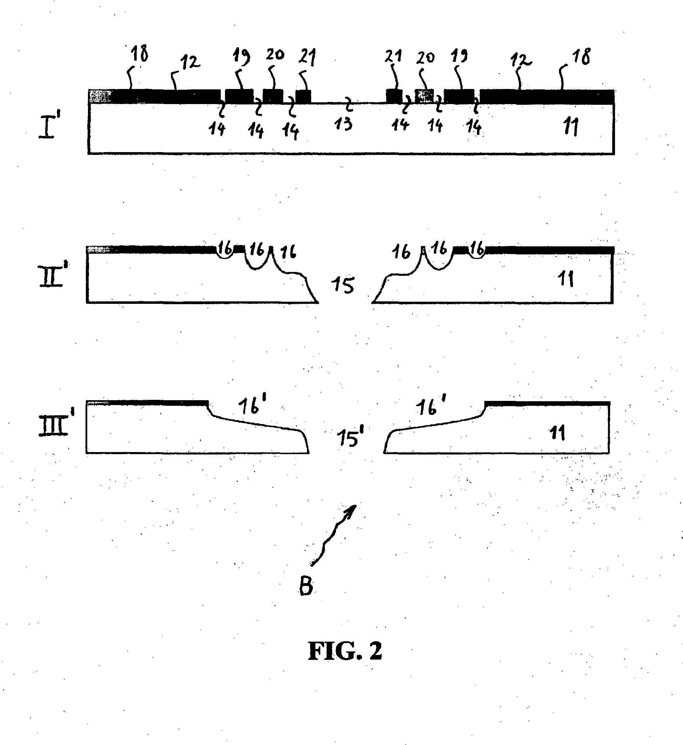

Figure 2 shows schematically a process (I'-III') for manufacturing a microstructure (B). Use is once again made (I') of a substrate (11) having arranged thereon a mask layer (12) comprising a larger opening (13), a plurality of smaller openings (14), a first region with larger mask structures (18), a second region with smaller mask structures (19), a third region with even smaller mask structures (20) and a fourth region with still smaller mask structures (21). A start is made with isotropic etching, wherein 'etch lag' ensures that the etching speed for the smaller openings (14) is lower than for the larger opening (13). After a period of time (II') a larger and deeper passage (15) is created in addition to multiple smaller and shallower cavities (16). The process and the pattern (13,14,18-21) of mask layer (12) are chosen such that at that point in time (II') the mask layer in the second region and the third region is almost wholly worn away, and in the fourth region wholly worn away, by a combination of vertical and horizontal mask erosion, while the thickness of the mask layer is still sufficient in the first region to protect the underlying material. Etching is then continued, wherein the mask layer is wholly worn away, first in the third region and then also in the second region, and the desired microstructure (B) is finally created. In a single process step and with a single mask layer (12) a microstructure (B) can thus be manufactured which comprises a passage (15') and a downward sloping recess (16'). The part of the mask layer in the second region and the third region almost wholly worn away following step I'-II' can optionally also be removed by means of powder blasting, after which the etching is resumed in order to arrive at the desired structure (B).

The technique can in principle also be applied with all kinds of material. What is essential is that a combined use is made on the one hand of the phenomenon of 'blast lag' and/or 'etch lag' and on the other of the phenomenon of 'mask erosion' by powder blasting and/or etching with a single mask layer having openings and structures of varying dimensions in order to thus realize a determined microstructure, and in some cases in a single process step.

## Claims

1. Method for manufacturing a microstructure (A), wherein use is made of powder blasting, comprising the step of providing a substrate (1, 11) having arranged thereon a single mask layer (2) with a substantially uniform thickness with openings (3,4) and structures (7,8) of varying dimensions, further comprising at least one of the steps of:
powder blasting the mask layer and the substrate until at least one given point in time, wherein the blasting speed for smaller sized openings (4) is lower than for larger openings (3) due to blast lag, and wherein the mask layer has been wholly worn away within at least one region by mask erosion while the microstructure is not yet wholly realized; and
etching the mask layer and the substrate until at least one given point in time wherein the etching speed for smaller sized openings (14) is lower than for larger openings (13) due to etch lag, and wherein the mask layer has been wholly worn away within at least one region by mask erosion while the microstructure is not yet wholly realized.

2. Method as claimed in claim 1, **characterized in that** the method further comprises the step of:
powder blasting the mask layer and the substrate after the at least one given point in time until the microstructure is fully realized.

3. Method as claimed in claim 1 or 2, **characterized in that** the method further comprises the step of:
etching the mask layer and the microstructure after the at least one given point in time until the microstructure is fully realized.

4. Method for manufacturing a microstructure (B), wherein use is made of etching, comprising the step of providing a substrate (1, 11) having arranged thereon a single mask layer (2) with a substantially uniform thickness with openings (3,4) and structures (7,8) of varying dimensions, further comprising at least one of the steps of:
powder blasting the mask layer and the substrate until at least one given point in time, wherein the blasting speed for smaller sized openings (4) is lower than for larger openings (3) due to blast lag, and wherein the mask layer has been wholly worn away within at least one region by mask erosion while the microstructure is not yet wholly realized; and
etching the mask layer and the substrate until at least one given point in time wherein the etching speed for smaller sized openings (14) is lower than for larger openings (13) due to etch lag, and wherein the mask layer has been wholly worn away within at least one region by mask erosion while the microstructure is not yet wholly realized.

5. Method as claimed in claim 4, **characterized in that** the method further comprises the step of:
powder blasting the mask layer and the substrate after the at least one given point in time until the microstructure is fully realized.

6. Method as claimed in claim 4 or 5, **characterized in that** the method further comprises the step of:
etching the mask layer and the microstructure after the at least one given point in time until the microstructure is fully realized.

## Patentansprüche

1. Verfahren zum Herstellen einer Mikrostruktur (A), wobei Pulverstrahlen verwendet wird, aufweisend den Schritt des Bereitstellens eines Substrats (1, 11), auf welchem eine einzelne/einzige Maskenschicht (2) mit einer im Wesentlichen einheitlichen Dicke, mit Öffnungen (3,4) und Strukturen (7,8) variabler Dimensionen angeordnet ist, ferner aufweisend zumindest einen der Schritte des:
Pulverstrahlens der Maskenschicht und des Substrats bis zu zumindest einem gegebenen Zeitpunkt, wobei die Abstrahlgeschwindigkeit aufgrund von Abstrahlverzögerung für kleinere Öffnungen (4) kleiner als für größere Öffnungen (3) ist und wobei die Maskenschicht innerhalb zumindest eines Bereichs durch Maskenerosion vollständig abgetragen wurde, während die Mikrostruktur noch nicht vollständig verwirklicht ist; und
Ätzens der Maskenschicht und des Substrats bis zu zumindest einem gegebenen Zeitpunkt, wobei die Ätzgeschwindigkeit aufgrund von Ätzverzögerung für kleinere Öffnungen (14) kleiner als für größere Öffnungen (13) ist und wobei die Maskenschicht innerhalb zumindest eines Bereichs durch Maskenerosion vollständig abgetragen wurde, während die Mikrostruktur noch nicht vollständig verwirklicht ist.

2. Verfahren wie in Anspruch 1 beansprucht, **dadurch gekennzeichnet, dass** das Verfahren ferner aufweist den Schritt des:
Pulverstrahlens der Maskenschicht und des Substrats nach dem zumindest einen gegebenen Zeitpunkt bis die Mikrostruktur vollständig verwirklicht ist.

3. Verfahren wie in Anspruch 1 oder 2 beansprucht, **dadurch gekennzeichnet, dass** das Verfahren ferner aufweist den Schritt des:
Ätzens der Maskenschicht und der Mikrostruktur nach dem zumindest einen gegebenen Zeitpunkt bis die Mikrostruktur vollständig verwirklicht ist.

4. Verfahren zum Herstellen einer Mikrostruktur (B), wobei Ätzen verwendet wird, aufweisend den Schritt des Bereitstellens eines Substrats (1, 11), auf welchem eine einzelne/einzige Maskenschicht (2) mit einer im Wesentlichen einheitlichen Dicke, mit Öffnungen (3,4) und Strukturen (7,8) variabler Dimensionen angeordnet ist, ferner aufweisend zumindest einen der Schritte des:
Pulverstrahlens der Maskenschicht und des Substrats bis zu zumindest einem gegebenen Zeitpunkt, wobei die Abstrahlgeschwindigkeit aufgrund von Abstrahlverzögerung für kleinere Öffnungen (4) kleiner als für größere Öffnungen (3) ist und wobei die Maskenschicht innerhalb zumindest eines Bereichs durch Maskenerosion vollständig abgetragen wurde, während die Mikrostruktur noch nicht vollständig verwirklicht ist; und
Ätzens der Maskenschicht und des Substrats bis zu zumindest einem gegebenen Zeitpunkt, wobei die Ätzgeschwindigkeit aufgrund von Ätzverzögerung für kleinere Öffnungen (14) kleiner als für größere Öffnungen (13) ist und wobei die Maskenschicht innerhalb zumindest eines Bereichs durch Maskenerosion vollständig abgetragen wurde, während die Mikrostruktur noch nicht vollständig verwirklicht ist.

5. Verfahren wie in Anspruch 4 beansprucht, **dadurch gekennzeichnet, dass** das Verfahren ferner aufweist den Schritt des:
Pulverstrahlens der Maskenschicht und des Substrats nach dem zumindest einen gegebenen Zeitpunkt bis die Mikrostruktur vollständig verwirklicht ist.

6. Verfahren wie in Anspruch 4 oder 5 beansprucht, **dadurch gekennzeichnet, dass** das Verfahren ferner aufweist den Schritt des:
Ätzens der Maskenschicht und der Mikrostruktur nach dem zumindest einen gegebenen Zeitpunkt bis die Mikrostruktur vollständig verwirklicht ist.

## Revendications

1. Procédé de fabrication d'une microstructure (A), dans lequel une attaque par projection de poudre est utilisée, comprenant l'étape de préparation d'un substrat (1, 11) sur lequel est agencée une seule couche de masque (2) présentant une épaisseur sensiblement uniforme ayant des ouvertures (3, 4) et des structures (7, 8) de dimensions variables, comprenant en outre au moins l'une des étapes de :
attaque par projection de poudre sur la couche de masque et le substrat jusqu'à au moins un instant donné, dans laquelle la vitesse de projection pour des ouvertures de plus faible taille (4) est inférieure à celle pour des ouvertures plus grandes (3) du fait du retard d'attaque par projection, et dans laquelle la couche de masque a été entièrement éliminée par usure, à l'intérieur d'au moins une zone, par érosion de masque alors que la microstructure n'est pas encore entièrement achevée ; et
gravure de la couche de masque et du substrat jusqu'à au moins un instant donné, dans laquelle la vitesse de gravure pour des ouvertures de plus faible taille (14) est inférieure à celle pour des ouvertures de taille plus grande (13) du fait du retard de gravure, et dans laquelle la couche de masque a été entièrement éliminée par usure, à l'intérieur d'au moins une zone, par érosion de masque alors que la microstructure n'est pas encore entièrement achevée.

2. Procédé selon la revendication 1, **caractérisé en ce que** le procédé comprend en outre l'étape de :
attaque par projection de poudre sur la couche de masque et le substrat après le au moins un instant donné jusqu'à ce que la microstructure soit entièrement achevée.

3. Procédé selon la revendication 1 ou 2, **caractérisé en ce que** le procédé comprend en outre l'étape de :
gravure de la couche de masque et de la microstructure après le au moins un instant donné jusqu'à ce que la microstructure soit entièrement achevée.

4. Procédé de fabrication d'une microstructure (B), dans lequel la gravure est utilisée, comprenant l'étape de préparation d'un substrat (1, 11) sur lequel est agencée une seule couche de masque (2) présentant une épaisseur sensiblement uniforme ayant des ouvertures (3, 4) et des structures (7, 8) de dimensions variables, comprenant en outre au moins l'une des étapes de :
attaque par projection de poudre sur la couche de masque et le substrat jusqu'à au moins un instant donné, dans laquelle la vitesse d'attaque par projection pour des ouvertures de plus faible taille (4) est inférieure à celle pour des ouvertures de taille plus grande (3) du fait du retard d'attaque par projection, et dans laquelle la couche de masque a été entièrement éliminée par usure, à l'intérieur d'au moins une zone, par érosion de masque alors que la micro structure n'est pas encore entièrement achevée ; et
gravure de la couche de masque et du substrat jusqu'à au moins un instant donné, dans laquelle la vitesse de gravure pour des ouvertures de plus faible taille (14) est inférieure à celle pour des ouvertures de taille plus grande (13) du fait du retard de gravure, et dans laquelle la couche de masque a été entièrement éliminée par usure, à l'intérieur d'au moins une zone, par érosion de masque alors que la microstructure n'est pas encore entièrement achevée.

5. Procédé selon la revendication 4, **caractérisé en ce que** le procédé comprend en outre l'étape de :
attaque par projection de poudre sur la couche de masque et le substrat après le au moins un instant donné jusqu'à ce que la microstructure soit entièrement achevée.

6. Procédé selon la revendication 4 ou 5, **caractérisé en ce que** le procédé comprend en outre l'étape de :
gravure de la couche de masque et de la microstructure après le au moins un instant donné jusqu'à ce que la microstructure soit entièrement achevée.
